# EUROPEAN PATENT APPLICATION

(11) **EP 4 471 868 A1**
(43) Date of publication of application: **04.12.2024**
(21) Application number: 24179211.8
(22) Date of filing: 31.05.2024
(51) Int. Cl.: H01L 29/423, H01L 21/28, H01L 29/78

(54) **SEMICONDUCTOR DEVICE**

(30) Priority: 02.06.2023 KR 20230071463; 28.05.2024 KR 20240069129
(71) Applicant: LX Semicon Co., Ltd., Daejeon 34027 (KR)
(72) Inventor: CHOI, Kee Joon, 34027 Daejeon (KR)
(74) Representative: Ter Meer Steinmeister & Partner

(57) **Abstract**

The present disclosure relates to a semiconductor device, and more particularly, to a metal-oxide semiconductor device. The semiconductor device according to an embodiment of the present disclosure may include: an active region including a channel area disposed between a first region and a second region which have a first conductivity and are spaced apart from each other; a gate oxide layer disposed on the active region; and a gate metal layer disposed on the gate oxide layer, wherein at least any one of the gate oxide layer and the gate metal layer includes a first portion located inside the active region and second portions extended and located outside the active region.

## Description

### BACKGROUND

### Field

The present disclosure relates to a semiconductor device, and more particularly, to a metal-oxide semiconductor device.

### Description of Related Art

A semiconductor device included in various electronic devices including home appliances is an important composition that determines the quality of the electronic devices. With the trend of mass capacity, multi-functionality, and/or miniaturization of the electronic devices, demand for a semiconductor device having improved reliability and other characteristics is increasing.

Many devices require metal-oxide-semiconductor (MOS) devices that are operable for low-voltage applications and high-voltage applications.

As an example, a display panel, such as a liquid crystal display (LCD) or an organic light-emitting display, and power devices, such as driving integrated circuits (ICs), require all of a low-voltage (LV) operation for driving related logical circuits and a high-voltage (HV) operation for driving the panel in operation.

Such low-voltage operations and high-voltage operations may be implemented by a semiconductor apparatus in which a plurality of semiconductor devices are integrated. However, in such a semiconductor apparatus in which a plurality of semiconductor devices are formed by neighbors, space efficiency may be an issue.

Meanwhile, in a state where a voltage is not applied to a gate (gate-off state) in a semiconductor device, leakage current may occur.

Accordingly, there is a need for schemes to solve the above problems.

### SUMMARY

According to an embodiment of the present disclosure, a semiconductor device which is capable of improving space efficiency in configuring a plurality of semiconductor devices is provided.

Further, according to an embodiment of the present disclosure, a semiconductor device which is capable of reducing or preventing an occurrence of leakage current is provided.

Further, a semiconductor device which is capable of reducing or preventing a hump phenomenon in which leakage current occurs due to an early turn-on is provided.

The object is solved by the features of the independent claims. Preferred embodiments are defined in the dependent claims.

In one aspect of the present disclosure to achieve the above objects, a semiconductor device may include: an active region including a channel area disposed between a first region and a second region which have a first conductivity and are spaced apart from each other; a gate oxide layer disposed on the active region; and a gate metal layer disposed on the gate oxide layer, wherein at least any one of the gate oxide layer and the gate metal layer includes a first portion located inside the active region and second portions extended and located outside the active region.

In an exemplary embodiment, the active region may have a first width in a direction that crosses the first region and the second region.

In an exemplary embodiment, the active region may have a second width that is vertical to the first width.

In an exemplary embodiment, the second portions may be extended and located outside with respect to the second width.

In an exemplary embodiment, the second parts may be disposed symmetrically to each other about a center of the second width.

In an exemplary embodiment, the first portion and the second portions may take a "T" shape.

In an exemplary embodiment, the gate oxide layer and the gate metal layer may have the same shape.

In an exemplary embodiment, each of the first region and the second region may include: a drift region having a first doping concentration; and a highly doped region located on an end side of the drift region and having a second doping concentration that is higher than the first doping concentration.

In an exemplary embodiment, the first portion and the second portions may be located to connect the drift regions with each other.

In another aspect of the present disclosure to achieve the above objects, a semiconductor device may include: a number of unit semiconductor devices including a first semiconductor device and a second semiconductor device formed on a substrate, wherein each of the number of the unit semiconductor devices includes: an active region including a channel area disposed between a first region and a second region which have a first conductivity and are spaced apart from each other; a gate oxide layer disposed on the active region; and a gate metal layer disposed on the gate oxide layer, and wherein at least any one of the gate oxide layer and the gate metal layer includes a first portion located inside the active region and second portions arts extended and located outside the active region.

In an exemplary embodiment, second portions of the first semiconductor device and second portions of the second semiconductor device may be connected with each other.

In an exemplary embodiment, in the first semiconductor device, the second portions may be located adjacent to the first region, and in the second semiconductor device, the second portions may be located adjacent to the second region.

According to an exemplary embodiment of the present disclosure, the following effects may maybe obtained.

First, according to an embodiment of the present disclosure, in configuring a plurality of semiconductor devices, the space efficiency may be improved.

As an example, in the overall semiconductor apparatus, it is possible to efficiently use the space. Accordingly, it is possible to produce a greater number of unit semiconductor devices in the same area.

Further, according to an embodiment of the present disclosure, it is possible to reduce or prevent an occurrence of the leakage current in the semiconductor device.

Further, in the semiconductor device, it is possible to reduce or prevent the hump phenomenon in which the leakage current occurs due to the early turn-on.

Furthermore, according to another embodiment of the present disclosure, there are additional technical effects that are not mentioned herein. Those skilled in the art may understand the technical effects through the whole purport of the specification and drawings.

### BRIEF DESCRIPTION OF THE DRAWINGS

The above and other objects, features, and advantages of the present disclosure will become more apparent to those of ordinary skill in the art by describing exemplary embodiments thereof in detail with reference to the attached drawings, in which:
FIG. 1 is a conceptual view illustrating an example of a MOS transistor device that may be applied to the present disclosure;
FIG. 2 is a conceptual view illustrating another example of a MOS transistor device that may be applied to the present disclosure;
FIG. 3 is a conceptual view illustrating still another example of a MOS transistor device that may be applied to the present disclosure;
FIG. 4 is a plan view illustrating a semiconductor device of a first embodiment of the disclosure;
FIG. 5 is a plan view illustrating a state where a plurality of semiconductor devices are formed according to a first embodiment of the present disclosure;
FIG. 6 a plan view illustrating a semiconductor device of a second embodiment of the disclosure;
FIG. 7 is a plan view illustrating a state where a plurality of semiconductor devices are formed according to a second embodiment of the present disclosure;
FIG. 8 a plan view illustrating a semiconductor device of a third embodiment of the disclosure;
FIG. 9 is a cross-sectional view taken along line D-D' of FIG. 8;
FIG. 10 is a cross-sectional view taken along line E-E' of FIG. 8;
FIG. 11 is a plan view illustrating an example of a state where a plurality of semiconductor devices are formed according to a third embodiment of the present disclosure;
FIG. 12 is a plan view illustrating another example of a state where a plurality of semiconductor devices are formed according to a third embodiment of the present disclosure; and
FIG. 13 a plan view illustrating a semiconductor device of a fourth embodiment of the disclosure.

### DETAILED DESCRIPTION OF EXEMPLARY EMBODIMENTS

Hereinafter, embodiments disclosed in the description will be described in detail with reference to the accompanying drawings, and the same reference numerals are given to the same or similar constituent elements regardless of the drawing symbols, and duplicate explanation thereof will be omitted. In the following description, suffixes "module" and "unit" for constituent elements, as used herein, are given or are interchangeably used in consideration of only easiness in preparing the description, but do not have mutually distinctive meanings or roles by themselves.

Further, in explaining the present disclosure, the detailed explanation of the related known technology will be omitted if it is determined that the explanation may obscure the gist of the embodiments disclosed in the description.

Further, the accompanying drawings are intended only to make the embodiments disclosed in the description readily understandable, and it should be noted that the technical idea disclosed in the description as being interpreted to be limited by the accompanying drawings.

Furthermore, although respective drawings are described for ease of explanation, it falls within the scope of the present disclosure that those skilled in the art will implement other embodiments by combining at least two or more drawings.

Further, when it is mentioned that a constituent element, such as a layer, a region, or a substrate, exists "on" another constituent element, it will be able to be understood that the element exists directly on the other element, or that an intermediate element may exist therebetween.

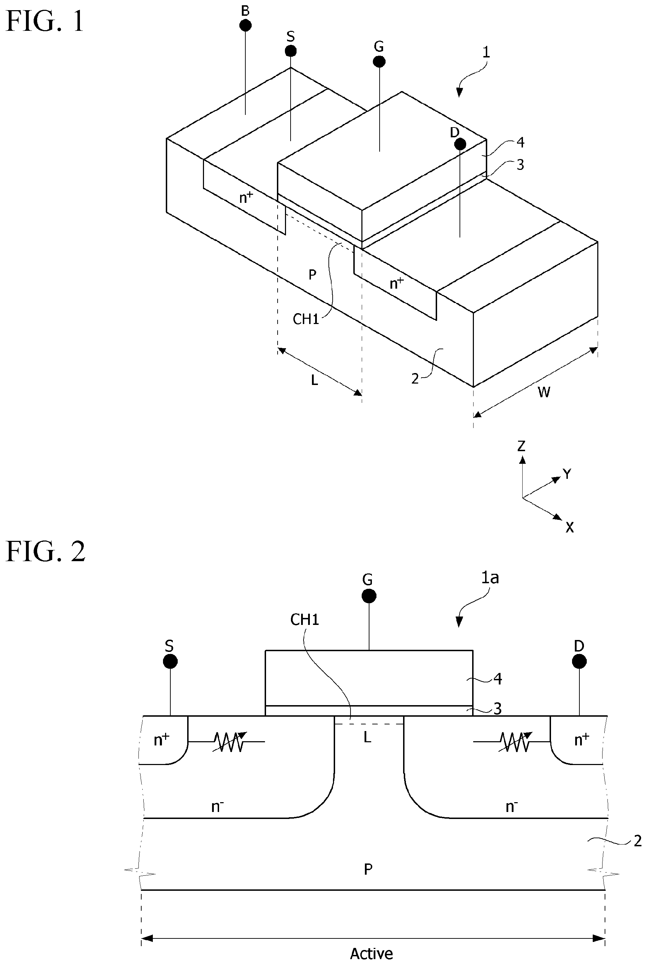

FIG. 1 is a conceptual view illustrating an example of a MOS transistor device that may be applied to the present disclosure.

As an example, a MOS transistor device may be a metal-oxide-semiconductor (MOS) transistor device having an n-type or a p-type channel.

Referring to FIG. 1, an n-type channel metal-oxide-semiconductor field effect transistor (MOSFET) device 1 formed on a p-type substrate 2 is illustrated. In such an n-type MOSFET device, a channel area CH1 having a predetermined width L may be located between two highly doped n-type regions (n+). The highly doped n-type regions (n+) may form a source region S and a drain region D. Further, on one side of the highly doped n-type region (n+), a body region B connected to the p-type substrate 2 may be provided. However, the present embodiments are not limited thereto. The body region B may be provided on a rear surface or a side surface of the p-type substrate 2.

Further, on the channel area CH1, a gate oxide layer 3 and a gate metal layer 4 that connect the source region S and the drain region D may be disposed.

The n-type MOSFET device 1 may have a unit device region having a predetermined width W in a vertical direction with respect to the width L of the channel. Such a unit device region may be called an active region.

The MOSFET device 1 may adjust the amount of current that flows between the source region S and the drain region D located on both sides thereof through the amount of voltage that is applied to a gate G. When the voltage is applied to the gate G, an n-type channel area may be formed to allow the current to flow through the channel.

The p-type MOSFET device may have a conductive type that is opposite to the conductive type as illustrated in FIG. 1. Except for the conductive type, the structure of the p-type MOSFET device may be substantially the same as the structure of the n-type MOSFET device 1.

FIG. 2 is a conceptual view illustrating another example of a MOS transistor device that may be applied to the present disclosure.

A display panel, such as a liquid crystal display (LCD) or an OLED display, and power devices, such as driving ICs, may require a low-voltage operation for driving related logical circuits and a high-voltage operation for driving the panel in operation.

Referring to FIG. 2, a high-voltage MOS transistor device (hereinafter, high-voltage MOS device (HVMOS)) 1a may include drift regions (drift n-) that substantially increase an operating voltage of the device. Such a high-voltage MOS device 1a may have a predetermined channel length L. FIG. 2 illustrates an example of an n-type high-voltage MOS device 1a.

In the high-voltage MOS device 1a, a p-type well P may be formed on a semiconductor thin film or a substrate. Typically, the p-type well P may have relatively low dopant concentration. The p-type well P may be the same layer as a portion of a thin film having p-type conductivity or a substrate, or may be a different layer from the portion of the thin film or the substrate.

Within a thin film 2 having the p-type well P, the drift regions (drift n-) having an opposite conductivity may be formed on both sides of the p-type well P.

In the drift region (drift: n-), a highly doped region (n+) constituting the source region S may be formed. The source region S may have an n-type conductivity that is opposite to the conductivity of the p-type well P. Further, in the drift region (drift: n-), a highly doped region (n+) constituting the drain region D may be formed. The drain region D may also have the n-type conductivity that is opposite to the conductivity of the p-type well P. The source region S and the drain region D may have the same conductivity as the drift region (drift: n-), but may have a higher dopant concentration.

A gate structure including the gate oxide layer 3 and the gate metal layer 4 may be formed on the channel area CH1. As an example, the gate oxide layer 3 may be formed on the channel area CH1, and the gate metal layer 4 may be formed on the gate oxide layer 3.

The p-type high-voltage MOS device may have conductivity opposite to the conductivity illustrated in FIG. 2. Except for the conductivity, the structure of the p-type high-voltage MOS device may be substantially the same as the structure of the n-type high-voltage MOS device 1a illustrated in FIG. 1.

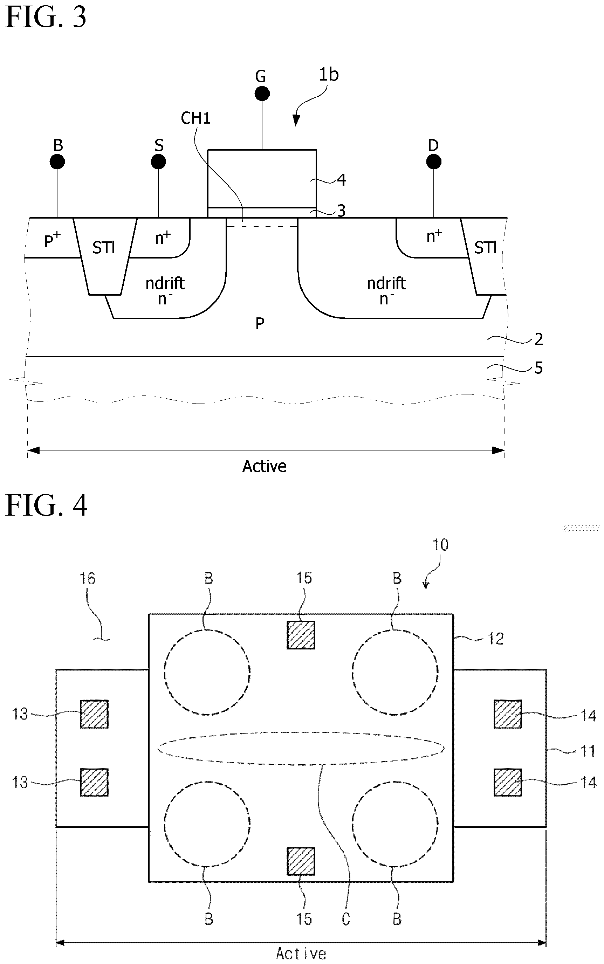

FIG. 3 is a cross-sectional view illustrating still another example of a MOS transistor device that may be applied to the present disclosure.

FIG. 3 illustrates an example of a detailed cross-sectional structure of a high-voltage MOS device 1b having the constitution as in FIG. 2.

As described above, in the high-voltage MOS device 1b, a p-type well P may be formed on a semiconductor thin film or a substrate 5. Typically, the p-type well P may have comparatively low dopant concentration. The p-type well P may be a portion of a thin film 2 or the substrate 5 having p-type conductivity.

Within the p-type well P, the drift regions (ndrift: n-) having an opposite conductivity may be formed on both sides of the channel area CH1.

In the drift region (drift: n-), a highly doped region (n+) constituting the source region S may be formed. The source region S may have an n-type conductivity that is opposite to the conductivity of the p-type well P. Further, in the drift region (drift: n-), a highly doped region (n+) constituting the drain region D may be formed. The drain region D may also have the n-type conductivity that is opposite to the conductivity of the p-type well P. The source region S and the drain region D may have the same conductivity as the drift region (drift: n-), but may have a higher dopant concentration.

A gate structure including the gate oxide layer 3 and the gate metal layer 4 may be formed on the channel area CH1. As an example, the gate oxide layer 3 may be formed on the channel area CH1, and the gate metal layer 4 may be formed on the gate oxide layer 3. Isolation structures, such as shallow trench isolation (STI) structures, may exist to isolate individual transistor devices.

The p-type high-voltage MOS device may have conductivity opposite to the conductivity illustrated in FIG. 2. Except for the conductivity, the structure of the p-type high-voltage MOS device may be substantially the same as the structure of the n-type high-voltage MOS device 1 illustrated in FIG. 1.

Hereinafter, in the semiconductor device according to the embodiments of the present disclosure to be described below, any one of the MOS transistor devices 1, 1a, and 1b as described above with reference to FIGS. 1 to 3 may be applied to an active region. Meanwhile, any type of semiconductor device having a different gate oxide layer and gate metal layer may be applied to the active region Active of the semiconductor device according to the embodiments of the present disclosure. For example, the semiconductor device may even be applied to various FinFet structures.

FIG. 4 is a plan view illustrating a semiconductor device according to a first embodiment of the present disclosure.

Referring to FIG. 4, an upper surface of a unit semiconductor device 10 according to a first embodiment is illustrated.

In such a semiconductor device, a gate metal layer 12 may be located on a semiconductor structure 11 having an active region Active. As described above, the semiconductor structure 11 having the active region Active may have any one of the structures of the MOS transistor devices 1, 1a, and 1b exemplarily described with reference to FIGS. 1 to 3.

On both sides of the gate metal layer 12 described above, at least one source contact 13 and drain contact 14 may be located. On the gate metal layer 12, at least one gate contact 15 may be located. The gate contact 15 may be disposed on an outside of the active region Active, but disposition of the gate contact 15 is not limited thereto.

On an outside of the semiconductor structure 11 described above, a body region 16 may be located on one side of the semiconductor substrate or the shallow trench isolation (STI) structure. The body region 16 may be an insulating region.

Here, the gate metal layer 12 may be formed with a size that is larger than the size of the semiconductor structure 11 having the active region Active.

By the gate metal layer 12 described above, five device regions B and C may be formed on the semiconductor device 10. That is, the region B that is formed along an outside of the gate metal layer 12 and the region C that is formed in the central portion of the gate metal layer 12 may be provided on the unit semiconductor device 10. The region B may be a region in which the gate metal layer 12 overlaps an edge of the active region Active.

The region B may be a low-voltage region having a relatively low voltage. As an example, the region B may be a region having a voltage that is lower than a threshold voltage of the semiconductor device 10. The region B may have the characteristic of being less affected by the surrounding electric field. Meanwhile, the region C may be a region having a middle voltage. The region C may be a region having a higher voltage than the voltage of the region B. The region C also has the characteristic of being less affected by having a surrounding electric field. However, the present embodiment is not limited thereto. For example, the region B may have a higher voltage than the voltage of the region C. The voltage difference between the region B and the region C may be because the thickness and the film quality of the gate oxide layer 3 may be different at the center and at the edge of the active region Active. Alternatively, the voltage difference may be due to the difference in dopant concentration between the P-well regions disposed at the lower portions of the region B and the region C.

In a state where the voltage is not applied to the gate (gate-off state) in the semiconductor device 10 as described above, the leakage current may not occur in the region B and the region C. That is, the region B and the region C may maintain a turn-off state, and the leakage current may be controlled.

Meanwhile, when the voltage (voltage that is lower than the threshold voltage) begins to be applied to the gate, a hump phenomenon in which the leakage current occurs due to an early turn-on may occur in the region B. Accordingly, the leakage current may occur in the region B between the source and the drain.

If the sufficient gate voltage that exceeds the threshold voltage is applied, the region B and the region C may be all turned on and may operate normally.

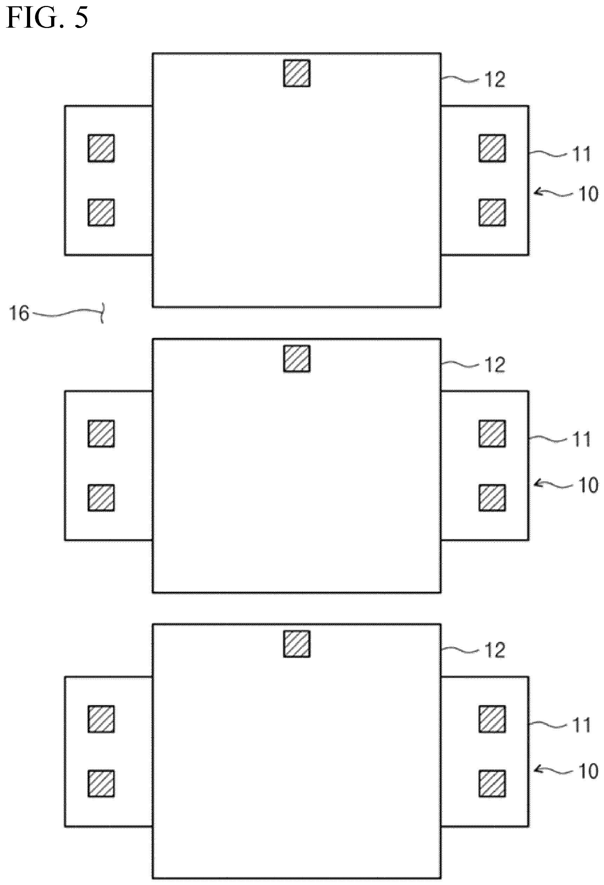

FIG. 5 is a plan view illustrating a state where a plurality of semiconductor devices are formed according to a first embodiment of the present disclosure.

Referring to FIG. 5, it is illustrated that a plurality of semiconductor devices 10 are formed adjacent to each other with a body region 16 therebetween on a wafer.

As described above, since the gate metal layer 12 is formed with a size that is larger than the size of the semiconductor structure 11 having the active region Active, the distance between the gate metal layers 12 of the adjacent unit semiconductor devices 10 should be secured in consideration of a device isolation region (e.g., shallow trench isolation (STI)), and thus the size of the region of the entire semiconductor device including a plurality of unit semiconductor devices 10 may be increased.

As an example, a digital-to-analogue converter (DAC) region of a display driver may have an effect on the size of the overall semiconductor device because the plurality of unit semiconductor devices 10 are repeatedly arranged therein.

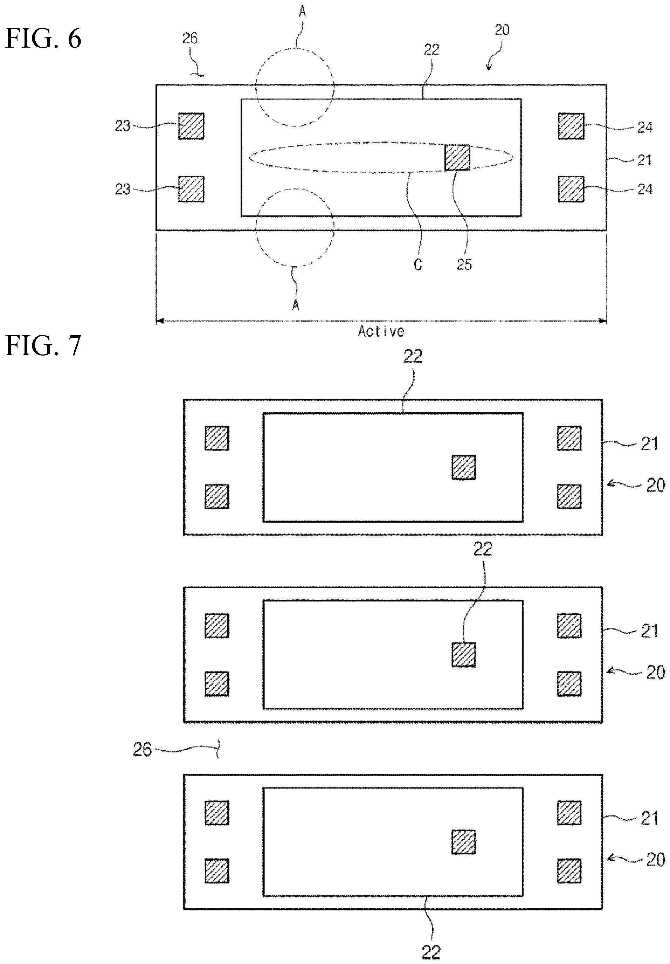

FIG. 6 is a plan view illustrating a semiconductor device according to a second embodiment of the present disclosure.

Referring to FIG. 6, an upper surface of a unit semiconductor device 20 according to the second embodiment is illustrated.

In such a semiconductor device 20, a gate metal layer 22 may be located on a semiconductor structure 21 having an active region Active. Here, as described above, the semiconductor structure 21 having the active region Active may have a structure of any one of the MOS transistor devices 1, 1a, and 1b as exemplarily described with reference to FIGs. 1 to 3.

On both sides of the gate metal layer 22 described above, at least one source contact 23 and drain contact 24 may be located. At least one gate contact 25 may be located on the gate metal layer 22.

On an outside of the semiconductor structure 21 described above, a body region 26, such as a semiconductor substrate or a shallow trench isolation (STI) structure, may be located.

Here, the gate metal layer 22 may be formed with a size that is smaller than the size of the semiconductor structure 21 having the active region Active. That is, the gate metal layer 22 may be disposed inside the active region Active on a plane.

By the gate metal layer 22 described above, two device regions A and C may be formed on the semiconductor device 20. That is, the region A that is formed along an outside of the gate metal layer 22 and the region C that is formed in the center part of the gate metal layer 22 may be provided on the unit semiconductor device 20. Here, the region A may be a region between the gate metal layer 22 and the edge of the active region Active. Since the gate metal layer 12 is not disposed on the region A, it may be a region where the transistor is not formed.

The region A may be a region having a relatively high voltage. Since the region A is not the region where the transistor is formed, it has the characteristic of being greatly affected by the surrounding electric field. Meanwhile, the region C may be a region having a medium voltage. Since the region C is shielded by the gate electrode layer 22, the region C has the characteristic of being less affected by the surrounding electric field.

In a state where the voltage is not applied to the gate (gate-off state) in the semiconductor device 10 as described above, the leakage current may occur in the region A. Accordingly, even if the gate voltage is not applied, the leakage current may abnormally occur between the source and the drain through the region A.

Meanwhile, if the voltage (voltage that is lower than the threshold voltage) begins to be applied to the gate, the region C may operate normally according to the threshold voltage. Further, if the sufficient gate voltage that exceeds the threshold voltage is applied, the region C may be turned on and may operate normally.

FIG. 7 is a plan view illustrating a state where a plurality of semiconductor devices are formed according to a second embodiment of the present disclosure.

Referring to FIG. 7, it is illustrated that a plurality of unit semiconductor devices 20 are formed adjacent to each other with a body region 26 interposed therebetween on a wafer.

As described above, since the gate metal layer 22 is formed with a size that is smaller than the size of the semiconductor structure 21 having the active region Active, it may be defined by the active region of the unit semiconductor device 20. Accordingly, in case that the plurality of unit semiconductor devices 20 are formed, the overall size of the semiconductor device may be reduced as compared to the semiconductor device 10 according to the first embodiment as described above.

However, as described above, in a state where the voltage is not applied to the gate (gate-off state) in the semiconductor device 20, the leakage current may occur in the region A (see FIG. 6) due to the influence of other adjacent unit semiconductor devices 20.

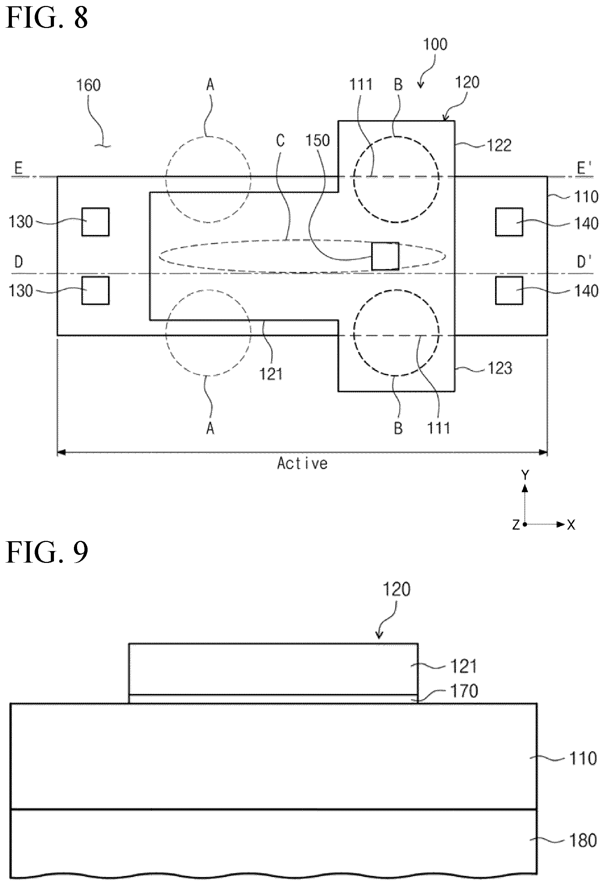

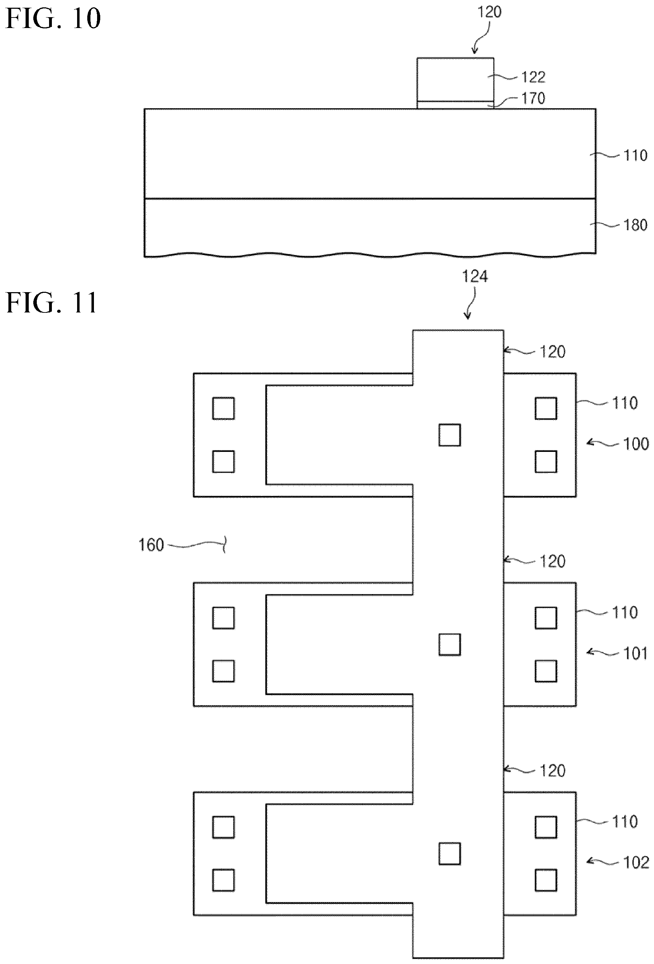

FIG. 8 is a plan view illustrating a semiconductor device according to a third embodiment of the present disclosure. FIG. 9 is a cross-sectional view taken along line D-D' of FIG. 8. FIG. 10 is a cross-sectional view taken along line E-E' of FIG. 8.

Referring to FIG. 8, an upper surface of a unit semiconductor device 100 according to the third embodiment is illustrated.

In such a semiconductor device 100, a gate metal layer 120 may be located on a semiconductor structure 110 having an active region Active. Here, as described above, the semiconductor structure 110 having the active region Active may have a structure of any one of the MOS transistor devices 1, 1a, and 1b as exemplarily described with reference to FIGs. 1 to 3.

Accordingly, the unit semiconductor device 100 may include: an active region 110 including a channel area CH1 formed between a first region (e.g., n+/n-) and a second region (e.g., n+/n-) which have a first conductivity and are spaced apart from each other; a gate oxide layer 170 (see FIGS. 9 and 10) disposed on the channel area CH1; and a gate metal layer 120 located on the gate oxide layer 170.

As an example, as illustrated in FIG. 3, each of the first region and the second region may include: a drift region (ndrift n-) having a first doping concentration; and a highly doped region (n+) located on an end side of the drift region (ndrift n-) and having a second doping concentration that is higher than the first doping concentration. In this example, a first portion 121 and second portions 122 and 123 may be located to connect the drift regions (ndrift n-) with each other.

In an exemplary embodiment, at least any one of the gate oxide layer 170 and the gate metal layer 120 may include the first portion 121 located inside the active region Active and the second portions 122 and 123 extended and located outside the active region Active. The first portion 121 may be disposed inside the active region Active on a plane. The second portions 122 and 123 may not overlap the active region Active on the plane. The first portion 121 may overlap the edge of the active region Active. The area of the first portion 121 may be larger than the area of the second portions 122 and 123.

As an example, the active region Active may have a first width (width indicated by an arrow in FIG. 8, Active) in a direction (X-axis direction) that crosses the first region and the second region, and a second width (e.g., W in FIG. 1) in a direction (Y-axis direction) that is vertical to the first width. In this case, the second portions 122 and 123 may be extended and located outside with respect to the second width W.

Further, as an example, the second portions 122 and 123 may be located symmetrically to each other about the center of the second width W. That is, the lengths by which the second portions 122 and 123 extend outside the active region Active may be the same.

In an exemplary embodiment, the first part 121 and the second portions 122 and 123 may take a "T" shape. However, of course, the first portion 121 and the second portions 122 and 123 may take other various shapes. As another example, the first part 121 and the second portions 122 and 123 may take a cross (+) shape.

Meanwhile, referring to FIGS. 9 and 10, the gate oxide layer 170 and the gate metal layer 120 may have the same shape. As described above, although having been simply illustrated, the semiconductor structure 110 may have the structure of any one of the MOS transistor devices 1, 1a, and 1b as described with reference to FIGs. 1 to 3.

On both sides of the gate metal layer 120, at least one source contact 130 and drain contact 140 may be located. On the gate metal layer 120, at least one gate contact 150 may be located.

On an outside of the semiconductor structure 110 described above, a body region 160, such as the semiconductor substrate or the shallow trench isolation (STI) structure, may be located.

By the gate metal layer 120 described above, three device regions A, B, and C may be formed on the semiconductor device 100. That is, on the unit semiconductor device 100, the region A that is formed along an outside of the first portion 121 of the gate metal layer 120, the region B that is formed on the boundary side of the active region Active in the second portions 122 and 123 of the gate metal layer 120, and the region C that is formed in the center part of the gate metal layer 120 may be provided. Here, the region A may be located at a portion that is far from the gate contact 150 on the gate metal layer 120.

The region A may be a region having a relatively high voltage. The region A has the characteristic of being greatly affected by the surrounding electric field. Meanwhile, the region B may be a region having a relatively low voltage. Further, the region C may be a region having a medium voltage. The region B and the region C as described above have the characteristic of being less affected by the surrounding electric field.

If an adjacent switch is turned on in a state where the voltage is not applied to the gate (gate-off state) in the semiconductor device 10 as described above, the leakage current may occur in the region A. However, since the region B and the region C maintain the turn-off state, the leakage current may be controlled by the region B and the region C. That is, since the region A is turned on, but the region B and the region C maintain the turn-off state, the leakage current may not occur in the unit semiconductor device 100.

Meanwhile, if the voltage (voltage that is lower than the threshold voltage) begins to be applied to the gate, an early turn-on may occur in the region B. Thereafter, if the sufficient gate voltage that exceeds the threshold voltage is applied, the region B and the region C may be all turned on and may operate normally. Since the gate voltage is applied to turn on the transistor, there is no problem with the operation even if the region B is earlier turned on.

However, the embodiments of the present disclosure are not limited thereto. In case that the gate oxide layer is adjusted so that the voltage of the region B becomes higher than the voltage of the region C, the region B is turned off before the region C is turned on, and thus the leakage current of the region A may be blocked until the transistor is turned on.

FIG. 11 is a plan view illustrating an example of a state where a plurality of semiconductor devices are formed according to a third embodiment of the present disclosure.

Referring to FIG. 11, a state is illustrated, where a plurality of unit semiconductor devices 100, 101, and 102 are formed adjacent to each other with a body region 160 interposed therebetween on a wafer. As an example, the first semiconductor device 100 and the second semiconductor device 101 may be formed adjacent to each other.

In FIG. 11, a state is illustrated, in which gate metal layers 120 of the unit semiconductor devices 100, 101, and 102 are connected to each other, and an interconnected gate metal layer 124 is provided in all or some semiconductor devices. Although FIG. 11 illustrates three unit semiconductor devices 100, 101, and 102, it may be understood that more or fewer semiconductor devices may be provided in the corresponding state.

In case that the gates are at the same potential when the plurality of semiconductor devices 100, 101, and 102 are driven, the interconnected gate metal layer 124 as illustrated in FIG. 11 may be used.

As an example, the second portion 122 of the first semiconductor device 100 and the second portion 123 of the second semiconductor device 101 may be connected to each other.

As described above, since the gate metal layer 120 includes the first portion 121 having a size that is smaller than the size of the semiconductor structure 110 having the active region Active and the second portions 122 and 123 having a size that is larger than the size of the semiconductor structure 110 having the active region Active, it is possible to efficiently use the space in the entire semiconductor device. Accordingly, a greater number of unit semiconductor devices 100, 101, and 102 may be produced in the same area. Further, the semiconductor device may be efficiently produced by forming the gate metal layer 124 on which the adjacent second portions 122 and 123 are connected to each other.

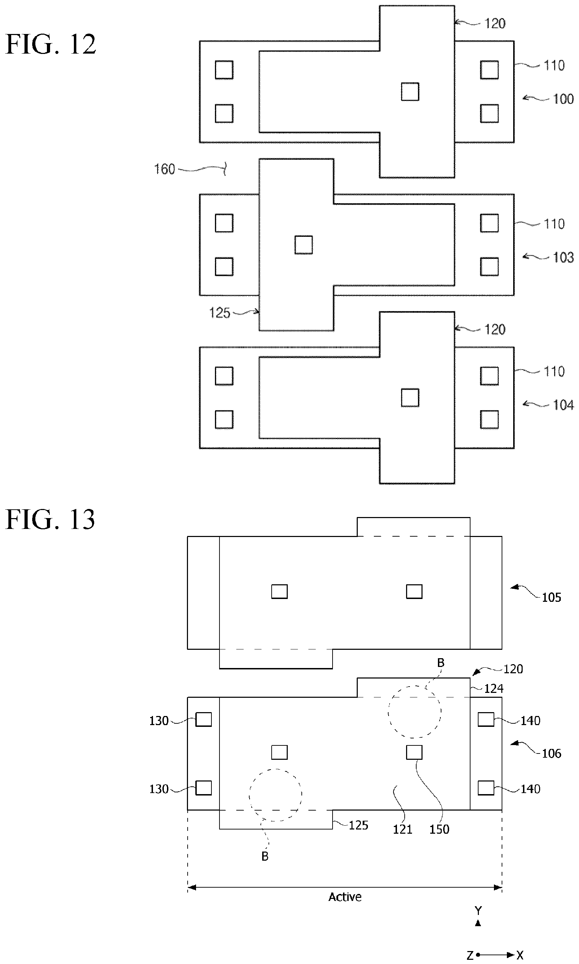

FIG. 12 is a plan view illustrating another example of a state where a plurality of semiconductor devices are formed according to the third embodiment of the present disclosure.

Referring to FIG. 12, a state is illustrated, in which a plurality of unit semiconductor devices 100, 103, and 104 are formed adjacent to each other on a wafer. As an example, the first semiconductor device 100 and the second semiconductor device 103 may be formed adjacent to each other.

In FIG. 12, a state is illustrated, in which gate metal layers 120 of the unit semiconductor devices 100, 103, and 104 are disposed in opposite directions in all or some semiconductor devices.

In an exemplary embodiment, in the first semiconductor device 100, the second portions 122 and 123 may be located adjacent to the first region (n+/n-), and in the second semiconductor device 103, the second portions 122 and 123 may be located adjacent to the second region (n+/n-).

In case that the gates G are not at the same potential in the plurality of semiconductor devices 100, 103, and 104, it is possible to efficiently use the space in the entire semiconductor device by forming the first portion 121 and the second portions 122 and 123 of the adjacent gate metal layers 120 to cross each other. Accordingly, as compared to the example illustrated in FIG. 11, a greater number of unit semiconductor devices 100, 103, and 104 may be produced in the same area.

FIG. 13 is a plan view illustrating a semiconductor device according to a fourth embodiment of the present disclosure.

Referring to FIG. 13, an upper surface of a unit semiconductor device 100 according to the fourth embodiment is illustrated.

In such a semiconductor device 100, a gate metal layer 120 may be located on a semiconductor structure 110 having an active region Active. Here, as described above, the semiconductor structure having the active region Active may have a structure of any one of the MOS transistor devices 1, 1a, and 1b as exemplarily described with reference to FIGS. 1 to 3.

Accordingly, the unit semiconductor device may include: an active region 110 including a channel area CH1 formed between a first region (e.g., n+/n-) and a second region (e.g., n+/n-) which have a first conductivity and are spaced apart from each other; a gate oxide layer 170 (refer to FIGs. 9 and 10) disposed on the channel area CH1; and a gate metal layer 120 located on the gate oxide layer 170.

In an exemplary embodiment, at least any one of the gate oxide layer 170 and the gate metal layer 120 may include the first portion 121 located inside the active region Active and third portions 124 and 125 extended and located outside the active region Active. The first portion 121 may overlap the active region Active on a plane, and the third portions 124 and 125 may not overlap the active region Active on the plane. The area of the first portion 121 may be larger than the area of the third portions 124 and 125.

The first portion 121 may be extended along the first direction (X-axis direction), and the third portions 124 and 125 may be extended in the second direction (Y-axis direction) that is vertical to the first direction, and may be formed outside the active region Active. Such a structure is the same as the structure of the third embodiment, but the third portions 124 and 125 may be arranged to deviate from each other in the second direction. That is, the (3-1)^{th} portion 124 and the (3-2)^{th} portion 125 may be arranged to deviate from each other without matching each other in the second direction.

By forming the first portion 121 and the third portions 124 and 125 of the gate metal layer 120 to cross each other in the plurality of semiconductor devices 105 and 106, it is possible to efficiently use the space in the entire semiconductor device. Accordingly, a greater number of unit semiconductor devices may be produced in the same area.

The foregoing description is only intended to illustrate the technical idea of the present disclosure by way of example, and various modifications and changes may be made by those of ordinary skill in the art to which the present disclosure pertains within the scope of not departing from the essential characteristics of the present disclosure.

Accordingly, embodiments disclosed in the present disclosure are not intended to limit the technical idea of the present disclosure, but to explain the same, and the technical idea of the present disclosure is not limited by such embodiments.

The scope of protection of the present disclosure should be interpreted by the appended claims, and it should be interpreted that all technical ideas within the equivalent range are included within the scope of the present disclosure.

### [Description of Reference Numerals]

| | | | |
|---|---|---|---|
| 100, 101, 102, 103, 104: | Semiconductor devices | | |
| 110: | Semiconductor structure, Active region | | |
| 120: | Gate metal layer | 130: | Source contact |
| 140: | Drain contact | 150: | Gate Contact |
| 160: | Body area | 170: | Gate oxide layer |

## Claims

1. A semiconductor device comprising:
an active region including a channel area disposed between a first region and a second region which have a first conductivity and are spaced apart from each other;
a gate oxide layer disposed on the active region; and
a gate metal layer disposed on the gate oxide layer,
wherein at least any one of the gate oxide layer and the gate metal layer includes a first portion located inside the active region and second portions extended and located outside the active region.

2. The semiconductor device of claim 1, wherein the active region has a first width in a direction that crosses the first region and the second region and a second width that is vertical to the first width, and
wherein the second portions are extended and located outside with respect to the second width.

3. The semiconductor device of claim 2, wherein the second portions are disposed symmetrically to each other about a center of the second width.

4. The semiconductor device of any one of the preceding claims, wherein the first portion and the second portions take a "T" shape.

5. The semiconductor device of any one of the preceding claims, wherein the gate oxide layer and the gate metal layer have the same shape.

6. The semiconductor device of any one of the preceding claims, wherein each of the first region and the second region includes:
a drift region having a first doping concentration; and
a highly doped region located on an end side of the drift region and having a second doping concentration that is higher than the first doping concentration.

7. The semiconductor device of claim 6, wherein the first portion and the second portions are located to connect the drift regions with each other.

8. The semiconductor device of any one of the preceding claims, further comprising a first device region disposed between the first portion and an edge of the active region, and a second device region in which the second portions and the active region overlap each other.

9. The semiconductor device of claim 8, wherein the first device region is a region where the gate metal layer and the active layer do not overlap each other and a transistor is not formed.

10. A semiconductor device comprising a number of unit semiconductor devices including a first semiconductor device and a second semiconductor device formed on a substrate, wherein each of the number of the unit semiconductor devices includes:
an active region including a channel area disposed between a first region and a second region which have a first conductivity and are spaced apart from each other;
a gate oxide layer disposed on the active region; and
a gate metal layer disposed on the gate oxide layer, and
wherein at least any one of the gate oxide layer and the gate metal layer includes a first portion located inside the active region and second portions extended and located outside the active region.

11. The semiconductor device of claim 10, wherein second portions of the first semiconductor device and second portions of the second semiconductor device are connected with each other.

12. The semiconductor device of claim 10 or 11, wherein in the first semiconductor device, the second portions are located adjacent to the first region, and in the second semiconductor device, the second portions are located adjacent to the second region.

13. A driver circuit comprising:
a plurality of semiconductor devices,
wherein each of the plurality of semiconductor devices includes:
an active region including a channel area disposed between a first region and a second region which have a first conductivity and are spaced apart from each other;
a gate oxide layer disposed on the active region; and
a gate metal layer disposed on the gate oxide layer, and
wherein at least any one of the gate oxide layer and the gate metal layer includes a first portion located inside the active region and second portions extended and located outside the active region.

14. The driver circuit of claim 13, wherein the active region has a first width in a direction that crosses the first region and the second region and a second width that is vertical to the first width, wherein the second portions are extended and located outside with respect to the second width.

15. The driver circuit of claim 14, wherein the second portions are disposed symmetrically to each other about a center of the second width.
